# EUROPEAN PATENT APPLICATION

(11) **EP 2 061 298 A2**
(43) Date of publication of application: **20.05.2009**
(21) Application number: 08253712.7
(22) Date of filing: 13.11.2008
(51) Int. Cl.: H05K 9/00

(54) **Shield case and printed circuit board assembly incorporating same**

(30) Priority: 14.11.2007 JP 2007295676
(71) Applicant: Hosiden Corporation, Yao-shi, Osaka 581-0071 (JP)
(72) Inventor: Ohtsuji, Takahisa, Osaka 581-0071 (JP); Nagata, Takayuki, Osaka 581-0071 (JP)
(74) Representative: Beresford, Keith Denis Lewis

(57) **Abstract**

The present invention aims to simplify earth wiring work of a shield case. A cable connector adapted to be attached to a distal end of a coaxial cable 50, includes a printed circuit board 10, a connector socket 20 mounted on the printed circuit board 10, a PCB holder 40 for holding the printed circuit board, and a shield case 30 for surrounding the printed circuit board 10 and the PCB holder 40. The shield case is of a two-piece construction including a first case 31 and a second case 32. The first case 31 has a strip 314. The distal end portion of the strip 314 has face-to-face contact with a shell 21 of the connector socket 20 through a terminal cutaway 324 formed in the second case 32.

## Description

The present invention relates to a shield case, most particularly to a shield case for a printed circuit board (PCB) assembly used in a connector and other devices with EMI (Electro Magnetic Interference) protection.

Electromagnetic waves emitted from electronic equipment such as television, refrigerator, electronic oven, personal computer, printer, and digital camera become a cause of communication failure and malfunction of other electronic equipment. Many countries of the world enhance regulations on guideline values for electromagnetic waves. Furthermore, the EMI noises tend to increase in the electronic equipment with higher performance.

So-called EMI countermeasure connectors of various types are proposed from many manufacturing companies to be used for wire cables for transmitting high-speed signals. Such connectors are strengthened in shield property etc., compared to connectors without EMI protection.

For instance, in a known connector incorporating an electronic component, the entire electronic component mounted on a printed circuit board is covered with a shield case, as described in Japanese Laid-Open Patent Publication No. 9-35820 etc.

In the above known connector, it is required not only to attach the shield case to the printed circuit board, but also to electrically connect an earth wiring formed on the printed circuit board to the shield case. The wiring work of the shield case is troublesome and it is thus difficult to reduce the cost of the connector. In particular, the assembly and wiring works become more difficult in a connector for a coaxial cable because its outer conductor needs to be connected to the earth wiring of the printed circuit board.

The present invention is contrived under the above situation and aims to provide a shield case that can simplify the earth wiring work of a printed circuit board assembly.

A shield case according to the present invention is a shield case for a printed circuit board assembly, said shield case being adapted, in use, to surround a printed circuit board having a component mounted thereon, or adapted, in use, to cover the component, the component having a ground/earth terminal in at least an outer face thereof, wherein the shield case includes a contact part for wire-free contact with said ground/earth terminal of the component.

A printed circuit board assembly according to the present invention includes a printed circuit board; a component adapted to be mounted on the printed circuit board, the component having a ground/earth terminal in at least an outer face thereof; and a shield case for surrounding the printed circuit board or covering the component. This basic configuration of printed circuit board assembly and shield case is no different from the conventional art. The inventors of the present invention include modifications centering on the shield case to achieve the above objective. As indicated in the preceding paragraph, the shield case has an additional feature of a contact part for contacting the ground/earth terminal of the component in a wire-free manner.

According to the present invention, when the printed circuit board and the shield case are assembled, the contact part of the shield case directly contacts the ground/earth terminal of the component to be brought into a conduction state. Unlike the conventional art, the invention can obviate a special earth wiring work for bringing the shield case and the component into conduction. As a result, assembling and wiring work of the assembly is facilitated compared to the conventional art, contributing to cost reduction.

If the assembly is destined to be attached to an end of a cable, the shield case may preferably have a cable opening for passing the end of the cable therethrough. If the component is a connector socket having a ground shell and is arranged at the end of the printed circuit board to face outward, the shield case may preferably have a plug opening on a front side thereof, the plug opening being adapted to pass through a connector plug to mate with the connector socket.

If the assembly is destined to be attached to an end of a coaxial cable, the shield case may preferably further include a connection piece provided near the cable opening, the connection piece being adapted to contact along an outer conductor at the end of the coaxial cable.

According to this aspect of the invention, electrical connection is established between the outer conductor of the coaxial cable and the shield case by simply passing the end of the coaxial cable through the cable opening of the shield case and bringing the connection piece of the shield case into contact with the outer conductor. Thus, special wiring work is unnecessary, further reducing the cost of the assembly.

Preferably, the shield case further includes a terminal opening for exposing the ground/earth terminal of the component, the terminal opening having a cantilever strip, the strip overhanging from an edge of the terminal opening. In this case, a distal end portion of the strip is contactable with the ground/earth terminal through the terminal opening so as to function as the contact part.

The distal end portion of the strip may be bent to have face-to-face contact with the ground/earth terminal of the component.

According to this aspect of the invention, a printed circuit board can be installed in the shield case without interference in a state where the shield case has few asperities before deforming the distal end portion of the strip of the shield case. After the installation is completed, the distal end portion of the strip can be bent for direct contact with the ground/earth terminal of the component. The invention thus facilitates assembly work, and further reduces the manufacturing cost of the shield case, which should lead to reduction in cost of the entire assembly.

The shield case having the terminal opening may preferably have a plurality of strips arranged in spaced relation to each other.

According to this aspect of the invention, although electromagnetic noise is apt to leak out from the terminal opening formed in the shield case, such leak can be reduced because most part of the terminal opening can be blocked with a plurality of strips.

The contact part may be fixed to the ground/earth terminal of the component by soldering.

This aspect of the invention can ensure a conductive state of the contact part and the ground/earth terminal of the component, bringing about a stronger shield effect.

If the component used in the assembly is a connector socket having a ground shell and if it is arranged at the end of the printed circuit board to face outward, it is preferable to add a PCB holder for holding the printed circuit board, the PCB holder being attachable into the shield case.

According to this aspect of the invention, the printed circuit board as held by the PCB holder can be incorporated in the shield case. Therefore, the printed circuit board can be incorporated in the shield case without the connector socket and other devices on the printed circuit board contacting the shield case. Consequently, the assembly work is facilitated, leading to a reduced cost of the assembly.

It is preferable that the PCB holder include a main body, which is a frame body of a substantially U shape in top view conforming to an outer shape of the printed circuit board, the main body being adapted to hold the printed circuit board inserted from an open end side thereof; and a coupling part for bridging across the open end side of the main body substantially at a right angle, the coupling part being arranged at a different height from the main body so as not to inhibit the insertion of the printed circuit board. In this case, the coupling part may have a cutaway for exposing the ground/earth terminal of the connector socket.

According to this aspect of the invention, when the printed circuit board and the PCB holder are combined, the connector socket does not get covered by the coupling part but is exposed through the cutaway. When the PCB holder is incorporated in the shield case in this state, the coupling part partly abuts the back surface of the front face of the shield case, so that the coupling part of the PCB holder reinforces the front face of the shield case. As a result, the invention obviates the need for providing a special reinforcing member, leading to further reduction in cost of the assembly.

Particularly if the assembly is attached to an end of a cable or a coaxial cable, the main body of the PCB holder may have grooves arrayed to guide inner conductor lines at the end of the cable or the coaxial cable.

This aspect of the invention allows the inner conductor lines taken out from the end of the cable or coaxial cable to be wired, in an inserted and temporarily fixed state in the grooves of the PCB holder, to the components on the printed circuit board. Thus, the wiring work is facilitated, leading to reduction in the cost of the assembly.

In the case of the printed circuit board assembly including the PCB holder, the shield case is preferably a two-piece construction including a first case having a PCB receiving port for receiving the PCB holder and the printed circuit board, and a second case for covering the PCB receiving port of the first case.

According to this aspect of the invention, the PCB holder and the printed circuit board are inserted into the first case of the shield case through the PCB receiving port, and then the first case and the second case can be combined. Thus, the assembly is simplified, leading to reduction in cost of the assembly.

If the component used in the assembly is a connector socket having a ground shell and if it is arranged at an end of the printed circuit board to face outward, the first case of the shield case may be formed with the PCB receiving port, the plug opening, the terminal opening and the strip, while the second case of the shield case may be formed with a terminal cover for partly covering the terminal opening when the second case is assembled with the first case. The terminal cover may have a terminal cutaway for passing the distal end portion of the strip therethrough. In this case, a distal end portion of the strip is contactable with the ground/earth terminal through the terminal opening and the terminal cutaway so as to function as the contact part.

According to this aspect of the invention, when the first case and the second case are combined, the terminal opening of the first case is partly covered by the terminal cover of the second case, and the distal end portion of the strip of the first case is located in the terminal cutaway of the second case. In this state, the distal end portion of the strip can be bent and brought into contact with the ground/earth terminal.

In addition to the terminal cover partly covering the terminal opening of the shield case, at least the basal end of the strip overlaps the terminal cover. The existence of such overlapping areas contributes to reduction in electrical resistance between the first case and the second case. Therefore, the invention effectively suppresses electromagnetic noises.

If the assembly is intended to be attached to an end of the cable, in use, the cable opening is preferably formed in the second case of the shield case. If the assembly is intended to be attached to an end of a coaxial cable, the cable opening and the connection piece are preferably formed in the second case.

The invention will now be described by way of example only with reference to the drawings, in which:
Fig. 1 is an upper perspective view seen from a front side of a cable connector according to an embodiment of a printed circuit board assembly of the present invention;
Fig. 2 is a perspective view of a printed circuit board of the cable connector;
Fig. 3 is a perspective view of the printed circuit board and a PCB holder of the cable connector, showing a state in which a shield case is detached from the cable connector;
Fig. 4 is a perspective view of the printed circuit board, the PCB holder and a first case of the shield case of the cable connector, showing a state in which the printed circuit board and the PCB holder shown in Fig. 3 are accommodated in the first case;
Fig. 5 is a perspective view of the cable connector, showing a state before strips of the shield case are bent;
Fig. 6 is an upper perspective view seen from a rear side of the cable connector, showing a state before the strips of the shield case are bent; and
Fig. 7 is a lower perspective view of the cable connector shown in Fig. 6.

### Component List

- A: CABLE CONNECTOR
- 10: PRINTED CIRCUIT BOARD
- 20: CONNECTOR SOCKET
- 21: SHELL
- 30: SHIELD CASE
- 31: FIRST CASE
- 311: PCB RECEIVING PORT
- 312: PLUG OPENING
- 313: TERMINAL OPENING
- 314: STRIP (CONTACT PART)
- 32: SECOND CASE
- 321: CABLE OPENING
- 322: CONNECTION PIECE
- 323: TERMINAL COVER
- 324: TERMINAL CUTAWAY
- 40: PCB HOLDER
- 41: MAIN BODY
- 411: BOARD RECEIVING GROOVE
- 412: GROOVE
- 42: COUPLING PART
- 421: CUTAWAY
- 50: COAXIAL CABLE
- 51: CORE WIRE (INNER CONDUCTOR)
- 52: BRAIDED WIRE (OUTER CONDUCTOR)

In the description which follows, relative spatial terms such as "upper", "lower", "left", "right", "top", etc., are used for the convenience of the skilled reader and refer to the orientation of the shield case and printed circuit board assembly and their constituent parts as depicted in the drawings. No limitation is intended by use of these terms, either in use of the invention, during its manufacture, shipment, custody, or sale, or during assembly of its constituent parts or when incorporated into or combined with other apparatus.

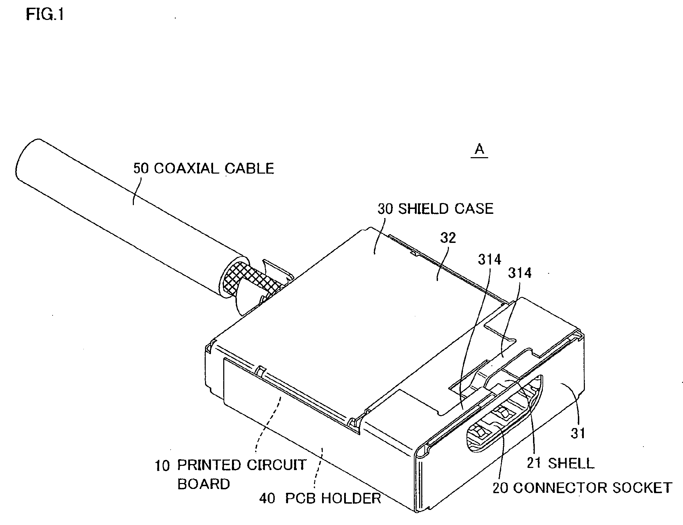

An embodiment of a printed circuit board assembly of the present invention will be described using a cable connector by way of example. Fig. 1 is a perspective view of a cable connector A. The figure shows a printed circuit board 10, a connector socket 20, a shield case 30, a PCB holder 40, and a coaxial cable 50.

The correspondence relationship between the component of the cable connector A and the inventive features recited in the claims is described in the component list which is a description of reference numerals.

The cable connector A is a connector with EMI protection having an embedded circuit attached at a distal end of the coaxial cable 50. The connector A includes the printed circuit board 10, the connector socket 20 mounted on the printed circuit board 10, the PCB holder 40 for holding the printed circuit board 10, and the shield case 30 surrounding the printed circuit board 10 and the PCB holder 40.

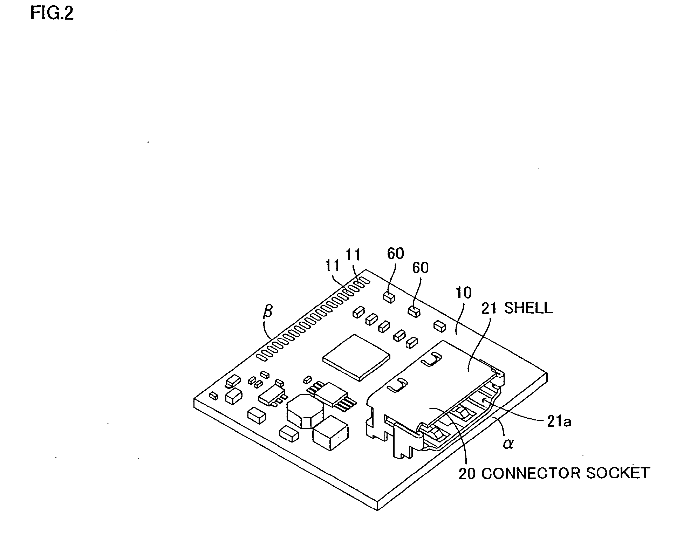

As shown in Fig. 2, the printed circuit board 10 is of a substantially square shape and formed with a buffer circuit, an amplification circuit, a signal conversion circuit and/or a filter circuit, etc. These circuits are implemented via various electronic components 60 mounted on a surface of the printed circuit board 10. For input and output of signal lines/power supply lines of the circuits, input/output terminals 11 or the like are formed in addition to the connector socket 20.

The connector socket 20 is arranged facing outward in the center of an end α of the printed circuit board 10 (end on the front side). More particularly, the connector socket 20 is arranged such that a plug receiving hole 21a of a shell 21 (described later in detail) of the socket 20 faces outward. The input/output terminals 11 are arranged at an equal pitch distance along an end β of the printed circuit board 10 (end on the rear side).

The connector socket 20 is a square connector for high-speed signal transmission, having a tubular shell 21 made of metal on the outside. Power supply pins/signal pins (not shown) are arranged inside the plug receiving hole 21a of the shell 21 to be electrically connected to the power supply lines/signal lines (not shown) arranged on the surface of the printed circuit board 10. When a plug (not shown) that mates with the connector socket 20 is connected to the socket, the shells of the mating socket and plug contact each other, so that electrical connection is established between the grounds/earths of the mating socket and plug. Since the shell 21 itself is a conductor, its outer face (outer top face in the present embodiment) functions as the ground/earth terminal.

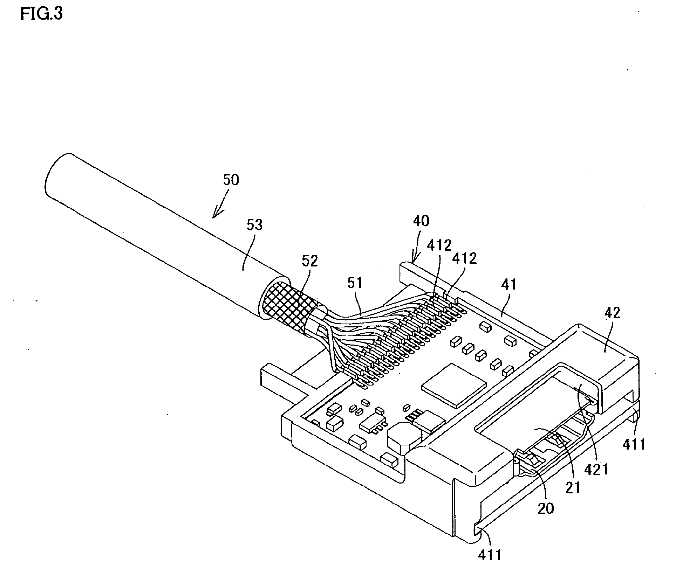

As shown in Fig. 3, the PCB holder 40 is attachable inside the shield case 30 and has a function of holding the printed circuit board 10. The PCB holder 40, molded of plastics material, consists of a main body 41 and a coupling part 42.

The main body 41 is a frame body of substantially U shape in top view conforming to an outer shape of the printed circuit board 10. The main body 41 is adapted to hold the printed circuit board 10 inserted from its opened end side (front side). Inner side surfaces of the main body 41 have board receiving grooves 411, 411 along their lengths. When the printed circuit board 10 is inserted from the opened end side of the main body 41, opposite side ends of the printed circuit board 10 enter the respective board receiving grooves 411, 411 so that the board receiving grooves 411, 411 hold the printed circuit board 10.

The opposite side of the opened end side (rear side) of the main body 41 has grooves 412 for guiding core wires 51 at the distal end of the coaxial cable 50, arrayed at the same pitch distance as the input/output terminals 11. In a state where the printed circuit board 10 is assembled in the PCB holder 40, the input/output terminals 11 of the printed circuit board 10 are in positions to face the associated grooves 412 of the PCB holder 40. The grooves 412 are substantially of U-shape in cross-section and capable of guiding and temporarily holding the core wires 51 at the distal end of the coaxial cable 50.

The coupling part 42 is substantially of U-shape in cross-section for bridging across the opened end side (front side) of the main body 41 substantially at right angles. The coupling part 42 is arranged as an upper step with respect to the main body 41 so as not to inhibit the insertion of the printed circuit board 10. The coupling part 42 is formed with a cutaway 421 for exposing the shell 21 of the connector socket 20. That is, in a state where the printed circuit board 10 is assembled in the PCB holder 40, the front end of the printed circuit board 10 is covered by the coupling part 42 of the PCB holder 40 but, as shown in Fig. 3, the shell 21 of the connector socket 20 is exposed through the cutaway 421.

The shield case 30, molded of metal, is of a two-piece construction including a first case 31 and a second case 32 as shown in Fig. 1.

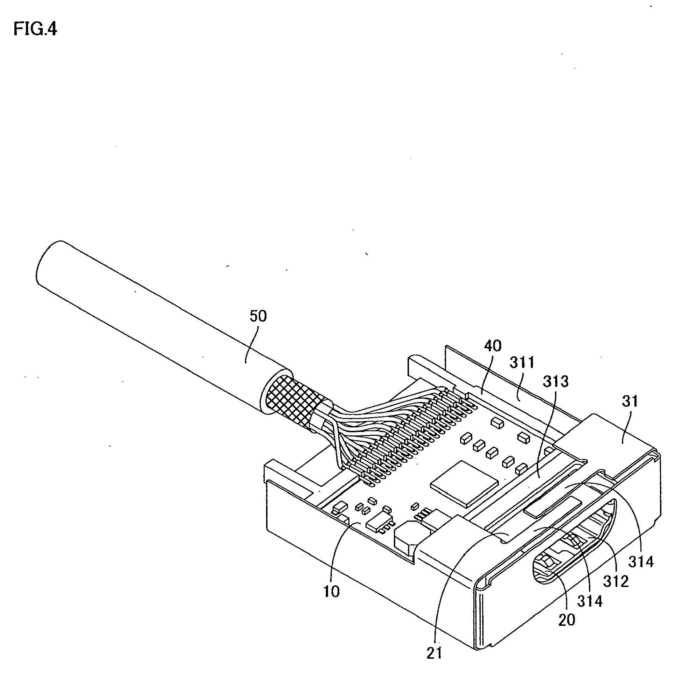

As shown in Fig. 4, the first case 31 has a box shape conforming to the outer shape of the PCB holder 40, with its upper surface being opened at the rear side. The rear side of the first case 31 is cut away to form a PCB receiving port 311 for receiving the PCB holder 40 and the printed circuit board 10. In addition to the PCB receiving port 311, the first case 31 also has a plug opening 312, a terminal opening 313, and strips 314.

The plug opening 312 is formed in the center of a front surface of the first case 31 and serves as an opening for inserting and removing the plug therethrough. That is, the plug can be connected to the connector socket 20 mounted on the printed circuit board 10 through the plug opening 312 of the first case 31.

The terminal opening 313 is formed in the upper face of the first case 31 and serves as an opening for exposing a part, mainly the shell 21, of the connector socket 20 mounted on the printed circuit board 10.

The strips 314 are cantilever pieces hanging over from the opposite edges of the terminal opening 313. Distal end portions of the strip 314 are bent to function as contact parts that contact the shell 21 of the connector socket 20 mounted on the printed circuit board 10. More specifically, the two strips 314 are staggered with spacing in between, extending from the left and right sides, respectively, of the terminal opening 313.

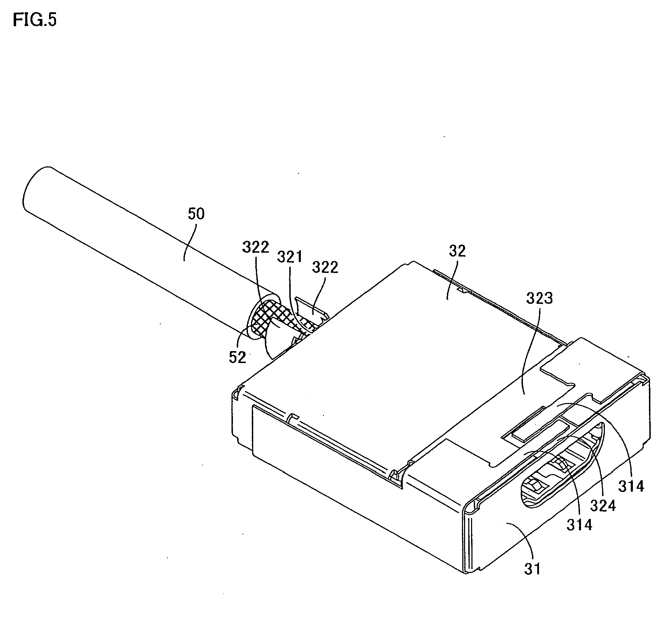

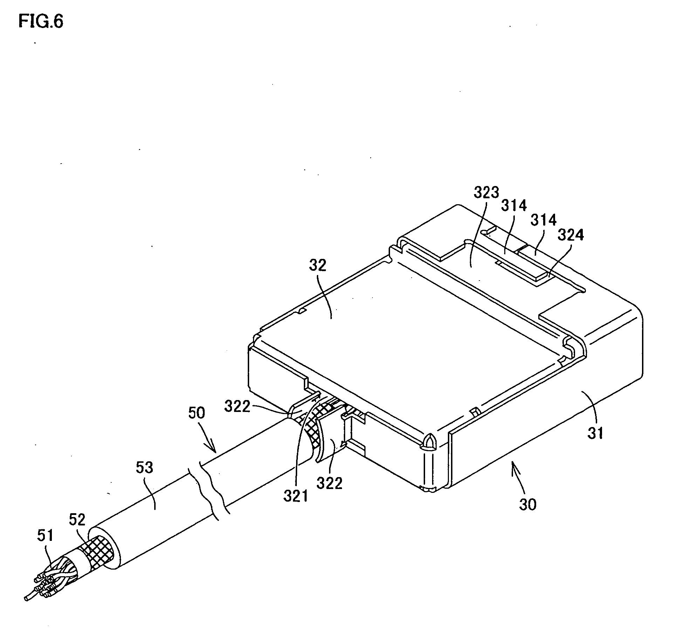

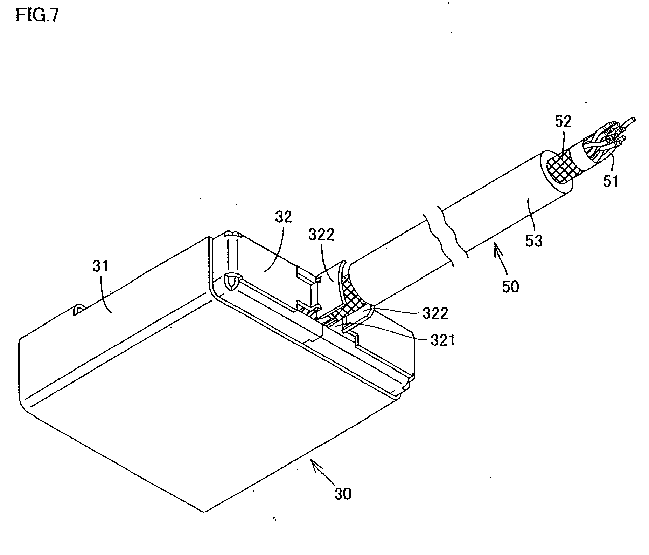

As shown in Fig. 5 to Fig. 7, the second case 32 has a box shape without two faces (lower and front faces) that would cover the PCB receiving port 311 of the first case 31. The second case 32 can be combined with the first case 31 by fitting over the upper side of the first case 31 and sliding towards the front.

The second case 32 is provided with a plate-like terminal cover 323 projecting from an upper surface thereof. The terminal cover 323 partly covers the terminal opening 313 (see Fig. 4) when the second case 32 is combined with the first case 31. A central part on a front surface side of the terminal cover 323 is cut away as a terminal cutaway 324 for passing through the distal end portions of the strip 314, 314.

In the center of a rear surface of the second case 32, a U-shaped cable opening 321 is formed for passing through the distal end of the coaxial cable 50. A pair of connection pieces 322 of circular arc shaped cross-section is provided on the left and right edges of the cable opening 321. The connection pieces 322 face each other and contact along braided wires 52 of the distal end of the coaxial cable 50. When the distal end of the coaxial cable 50 is passed through the cable opening 321 and the connection pieces 322 are slightly deformed inward, the connection pieces 322 face-to-face contact and electrically connect with the braided wire 52. Alternatively, the braided wires 52 and the connection piece 322 slightly deformed inward may be soldered for more secure electrical connection.

The cable connector A as described above is assembled in the following steps. First, the printed circuit board 10 shown in Fig. 2, with the electronic components 60 and the connector socket 20 mounted thereon, is set in the PCB holder 40, and the core wires 51 at the distal end of the coaxial cable 50 are connected by soldering to the input/output terminals 11 of the printed circuit board 10. This state is shown in Fig. 3.

The PCB holder 40 and the printed circuit board 10 as shown in Fig. 3 are inserted through the PCB receiving port 311 into the first case 31 of the shield case 30. This state is shown in Fig. 4. Thereafter, the first case 31 is combined with the second case 32. This state is shown in Fig. 5 to Fig. 7. In this state, the terminal cover 323 of the second case 32 is disposed under the top face of the first case 31, so that the terminal cover 323 partially overlaps opposite edges of the terminal opening 313 and overlaps basal ends of the strips 314, 314, and thereby the second case 32 is electrically connected to the first case 31. The overlapping areas contribute to reduction in electrical resistance between the second case 32 and the first case 31 so as to effectively suppress electromagnetic noise. Further, the distal end portions of the strips 314, 314 are disposed inside the terminal cutaway 324 of the second case 32.

When the first case 31 and the second case 32 are combined, the distal end of the coaxial cable 50 is disposed through the cable opening 321 of the second case 32. The connection pieces 322, 322 are then deformed slightly inward to electrically connect between the braided wire 52 of the coaxial cable 50 and the second case 32. Alternatively, the connection piece 322 slightly deformed inward is soldered to the braided wire 52 for more secure electrical connection.

The distal end portions of the strips 314, 314 are bent so as to be surface-contacted with the shell 21 of the connector socket 20 through the terminal opening 323 and the terminal cutaway 324. Thereafter, the respective distal end portions of the strip 314, 314 are fixed to the shell 21 of the connector socket 20 by soldering. The cable connector A is assembled in the above steps.

In the cable connector A, wiring work is significantly simplified compared to conventional connectors. Particularly, electrical connections are established all at once among the shell 21 of the connector socket 20, the shield case 30 and the braided wires 52 of the coaxial cable 50 by the above described simple step of bending the distal end portions of the strips 314, 314. It should be noted that, when the PCB holder 40 and the printed circuit board 10 are inserted into the first case 31 of the shield case 30, the strips 314, 314 are not yet bentthat is, the inner side of the first case 31 is free of asperities. Consequently, the PCB holder 40 and the printed circuit board 10 can be installed in the shield case 30 without interference, simplifying assembly work.

The assembly work can be simplified also because the printed circuit board 10 already held by the PCB holder 40 is incorporated in the shield case 30. That is, the printed circuit board 10 can be incorporated in the shield case 30 preventing the shield case 30 from contacting the connector socket 20, the electronic components 60 and other components mounted on the printed circuit board 10.

Further, the entire printed circuit board 10 is accommodated in the shield case 30 and most part of the terminal cutaway 324 is covered with the strips 314, 314. This construction can reduce leakage of electromagnetic noise and provide a high degree of noise shielding effect.

The connector A is also advantageous in that the front face of the shield case 30 has its rear side abutted by the coupling part 42 of the PCB holder 40. The front surface side of the shield case 30 is thus reinforced, and thereby a special reinforcement member becomes unnecessary.

Therefore, the cable connector A can achieve both reduced cost and improved performance.

The printed circuit board assembly according to the present invention is not limited to application to a cable connector connected to an end or both ends of a coaxial cable. The invention is similarly applicable to any type of printed circuit board with a shield case used for, for example, a transmitting or receiving device incorporated in a personal computer or a display monitor. The elements of the assembly of the embodiment may be modified as described below.

The printed circuit board is not limited to the printed circuit board 10 connected to an end of a coaxial cable 50 as described in the above embodiment. Instead, it may be a simple printed circuit board populated with a connector, terminals and/or other devices and installed in electronic equipment.

The shield case 30 may be modified in shape, etc., as appropriate to the type, position, and other configurations of devices mounted on the printed circuit board. The shield case may be a housing with a conductive thin-film formed on its inner surface. The shield case does not need to surround the entire printed circuit board but may cover devices mounted on the printed circuit board entirely or partially from above.

In particular, the contact part is not limited to the strips 314 of the embodiment described above but may take any other shape and any other configuration as long as it can contact the ground/earth terminal of the component when the shield case and the printed circuit board are assembled. For instance, a portion of the shield case may be bent into a protrusion, or a separately formed metal piece may be attached to the inner surface of the shield case.

The component is not limited to the connector socket 20 of the embodiment described above. Any component may be used as long as it has the ground/earth terminal at least in its outer face. For instance, the component may be an electronic component such as a transistor, a power supply terminal, as well as a high-speed signal transmission connector. In a component of any of these types, its case itself or terminals etc., arranged on the outer face of the case function as ground/earth terminals. The grounding of the ground/earth terminal is not limited to the mode carried out through the shield case, and may be a mode carried out through a ground/earth line provided on the printed circuit board. In this case, the shield case is grounded through a device on the printed circuit board or by other means.

The PCB holder can be omitted if the shield case covers the component instead of surrounding the printed circuit board. If the shield case surrounds the printed circuit board, the PCB holder 40 may be modified in design as long as the holder can be attached into the shield case and can hold the printed circuit board. Accordingly, the holder may be of any shape, material, etc., in accordance with the type, position, etc., of the component. In particular, the holder may be made of conductive material.

The cable is not limited to the coaxial cable 50 of the embodiment. It is possible to use a common cable or omit a cable, depending on the type of circuits fabricated on the printed circuit board.

## Claims

1. A shield case (30) for a printed circuit board assembly, said shield case being adapted to surround, in use, a printed circuit board (10) having a component (20) mounted thereon, or to cover, in use, the component, the component having a ground/earth terminal in at least an outer face thereof;
**characterized in that** the shield case includes a contact part (314) for wire-free contact with said ground/earth terminal of the component.

2. The shield case (30) according to claim 1 adapted to surround a printed circuit board (10) attached to an end of a cable (50), in use;
said shield case further including a cable opening (321) for receiving the end of an inserted cable therethrough.

3. The shield case (30) according to claim 1, said shield case being adapted to surround a printed circuit board (10) having a component (20) mounted thereon, said component (20) being a connector socket having a ground shell (21) and being arranged at an end of the printed circuit board (10) to face outward,
the shield case further including a plug opening (312) on a front side thereof, the plug opening being adapted to receive a connector plug to mate with the connector socket.

4. The shield case (30) according to claim 2 adapted to surround a printed circuit board (10) attached to an end of a coaxial cable (50), in use;
the shield case (30) further including a connection piece (322) provided near the cable opening (321), the connection piece being adapted to contact along an outer conductor (52) at the end of an inserted coaxial cable.

5. The shield case (30) according to claim 1, said shield case further including a terminal opening (313) for exposing the ground/earth terminal of a component (20) mounted on a printed circuit board (10) surrounded by the shield case, in use,
the terminal opening having a cantilever strip (314), the strip overhanging from an edge of the terminal opening,
wherein a distal end portion of the strip is contactable with the ground/earth terminal through the terminal opening so as to function as the contact part.

6. The shield case (30) according to claim 5,
wherein the distal end portion of the strip (314) is bent to have face-to-face contact with the ground/earth terminal of the component (20).

7. The shield case (30) according to claim 5,
the strip of the shield case (30) comprising a plurality of strips (314) arranged in spaced relation to each other.

8. The shield case (30) according to claim 1, wherein the contact part (314) is adapted to be fixed by soldering to the ground/earth terminal of a component (20) mounted on a printed circuit board (10) surrounded, in use, by the shield case (30).

9. The shield case (30) according to claim 3, further comprising a PCB holder (40) for holding a printed circuit board (10) surrounded by said shield case, in use, the PCB holder being attachable into the shield case (30).

10. The shield case (30) according to claim 9, the PCB holder (40) comprising:
a main body (41), which is a frame body of a substantially U shape in top view conforming to an outer shape of a surrounded printed circuit board (10), the main body being adapted to hold the printed circuit board inserted from an open end side thereof; and
a coupling part (42) for bridging across the open end side of the main body substantially at a right angle, the coupling part being arranged at a different height from the main body so as not to inhibit the insertion of the printed circuit board,
wherein the coupling part has a cutaway (421) for exposing the ground/earth terminal of the connector socket (20).

11. The shield case (30) according to claim 10 adapted to surround a printed circuit board (10) attached to an end of a cable (50) or a coaxial cable (50), in use;
the main body (41) of the PCB holder (40) having grooves (412) for guiding inner conductor lines (51) at the end of an inserted cable or coaxial cable.

12. The shield case (30) according to claim 9,
wherein the shield case is of a two-piece construction comprising:
a first case (31) having a PCB receiving port (311) for receiving the PCB holder (40) and a printed circuit board (10), held therein, and
a second case (32) for covering the PCB receiving port of the first case.

13. The shield case (30) according to claim 12,
wherein:
the first case (31) of the shield case (30) is formed with the PCB receiving port (311), the plug opening (312), a terminal opening (313) for exposing the ground/earth terminal of a component (20), mounted on a printed circuit board (10) surrounded by the shield case, in use, and a cantilever strip (314) overhanging from an edge of the terminal opening,
the second case (32) of the shield case includes a terminal cover (323) for partly covering the terminal opening when the second case is assembled with the first case,
the terminal cover has a terminal cutaway (324) for receiving the distal end portion of the strip therethrough, and
a distal end portion of the strip is contactable with the ground/earth terminal through the terminal opening and the terminal cutaway so as to function as the contact part.

14. The shield case (30) according to claim 12 adapted to surround a printed circuit board (10) attached to an end of a cable (50), in use, the second case (32) of the shield case (30) including a cable opening (321) for receiving the end of an inserted cable therethrough.

15. The shield case (30) according to claim 12 adapted to surround a printed circuit board (10) attached to an end of a coaxial cable (50), in use, the second case (32) of the shield case (30) including:
a cable opening (321) for receiving the end of an inserted coxial cable therethrough, and
a connection piece (322) provided near the cable opening, the connection piece being adapted to contact along an outer conductor (52) at the end of the coaxial cable.

16. A printed circuit board assembly comprising:
a printed circuit board (10);
a component (20) adapted to be mounted on the printed circuit board, the component having a ground/earth terminal in at least an outer face thereof; and
the shield case (30) according to any one of the preceding claims, the shield case being adapted to surround the printed circuit board, in use, or to cover the component mounted thereon, in use.
